# EUROPEAN PATENT SPECIFICATION

(11) **EP 0 715 414 B1**
(45) Date of publication and mention of the grant of the patent: **10.05.2000**
(21) Application number: 95300578.2
(22) Date of filing: 30.01.1995
(51) Int. Cl.: H03M 7/42

(54) **Variable-length encoder and decoding system**
Variables Längen-Kodier- und Dekodiersystem
Système de codage et décodage pour des mots code de longueur variable

(30) Priority: 30.11.1994 KR 9432215
(43) Date of publication of application: 05.06.1996
(73) Proprietor: Samsung Electronics Co., Ltd., Suwon-city, Kyungki-do 441-370 (KR)
(72) Inventor: Park, Ju-ha, Suwon-city, Kyungki-do (KR); Jeon, Byeung-woo, Pundang-gu, Sungnam-City, Kyungki-do (KR); Jeong, Jechang 1088-1007, Woosung Apt., Seoul (KR)
(74) Representative: Chugg, David John

(56) References cited:
- EP-A- 0 273 130
- EP-A- 0 613 303
- US-A- 5 253 053

## Description

The present invention relates to a variable-length encoding/decoding system for video data, and particularly, but not exclusively, to a variable-length encoding/decoding system using re-association of a predetermined relation of symbol-code word on the basis of occurring frequency of symbols to be variable-length coded (VLC), to thereby increase encoding efficiency.

Recently, video and audio equipment employing digital signal processing methods have increased in number and undergone brisk development, see e.g. US-A-5 253 053. As a consequence there have been a lot of studies into digital encoding of video and audio signals. Since an encoded video signal produces a great amount of digital data, various methods have been suggested to compress the encoded digital data prior to storing on a recording medium. Among the compression methods are a transform coding method, vector-quantization method, differential pulse coded modulation (DPCM), and variable-length coding method. Such coding methods are used to remove redundant data contained in a digital signal and thus reduce the whole amount of transmitted or recorded data.

The VLC method is a technique to convert symbols in the form of [run, level] obtained through discrete cosine transform (DCT), quantization and zigzag scan, into corresponding code words, using a VLC table.

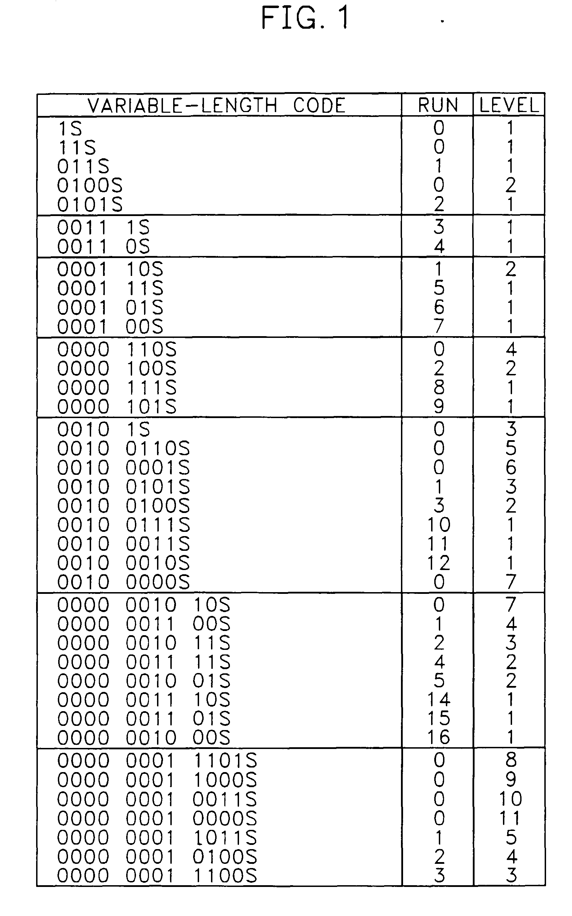

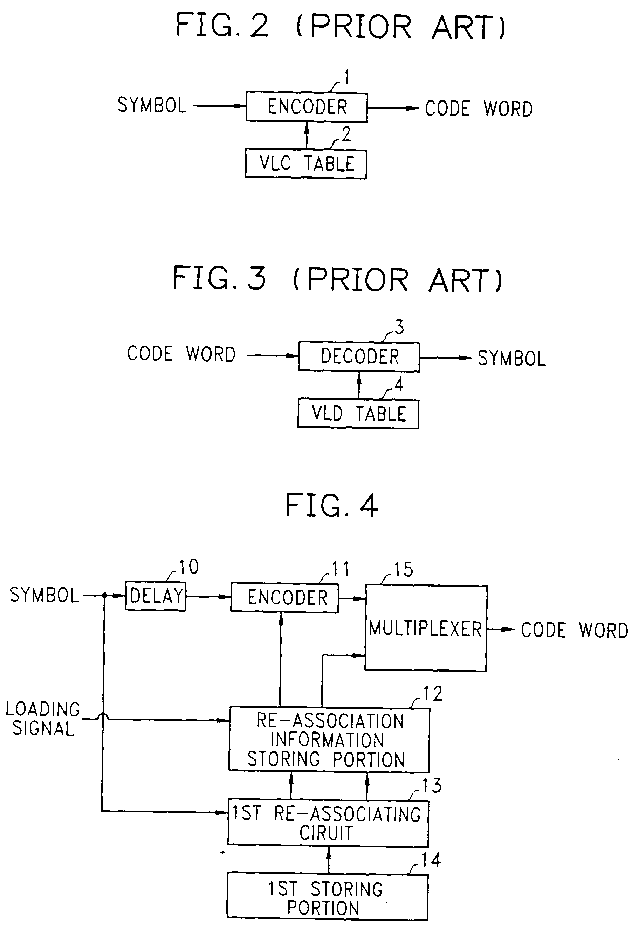

Figure 1 shows one example of VLC table. According to [run, level] of the symbols located on the right, code words of different lengths are associated to the respective symbols. The Huffman coding is a symbol-code word association method on the basis of frequency occurrence of symbols. That is, the Huffman coding is a data compression method in which, considering the frequency occurrence of a symbol, a code word of a shorter length is associated to a symbol having a higher occurring frequency while a code word of a longer length is associated to a symbol of a lower occurring frequency. A typical example of the above method is illustrated in Figure 2.

Figure 2 shows a conventional variable-length encoder, with Figure 3 depicting a conventional variable-length decoder. The variable-length encoder of Figure 2 comprises an encoder 1 and VLC table 2. The variable-length decoder of Figure 3 comprises a decoder 3 and VLD table 4 similar to VLC table 2. when a symbol is input, encoder 1 finds a code word corresponding to the input symbol out of code worlds input from VLC table 2, and outputs the corresponding code word. Decoder 3 finds a symbol corresponding to the input code word from VLD table 4, and outputs the corresponding symbol, to thereby restore the original symbol prior to encoding by the variable-length encoder.

However, if there is a difference between the occurring frequency of symbols used in constructing the VLC table 2 and the corresponding VLD table 4 and that of the symbols currently used in VLC coding, an optimum variable-length coding can not be achieved. In other words, if the characteristics of an image to be currently variable-length-coded are different from those of an image used when a code table is designed, the previously made VLC table 2 and VLD table 4 cannot be changed. This therefore leads to a less than optimum compression of the whole amount of data for storing or transmission.

With the above in mind, it is an aim of preferred embodiments of the present invention to provide a variable-length encoder in which, even though the symbol-code word association of a previously made code table is used, the occurring frequency of currently input symbols is measured to re-associate the symbols to the appropriate code words so that the amount of data to be consumed is reduced even when symbols having a different occurring frequency from that of symbols considered when the code table is made are input.

It is another aim to provide a variable-length decoder in which, in restoring the original symbols represented by the code words obtained by variable-length coding, a symbol corresponding to an input code word is searched in a previously made decode table according to symbol-code word re-association control information, to thereby decode the corresponding symbol.

According to a first aspect of the present invention, there is provided a variable-length encoder using symbol-code word re-association of a code table, the encoder comprising a first storing portion for storing a previously made code table information, a first re-associating portion for generating re-associated code table information and re-association information indicative of the relation of a symbol and a corresponding code word from the previously made code table information stored in the first storing portion, on basis of the occurring frequency of externally applied symbols for a predetermined time period, a delay for delaying and outputting the same symbols as those input to the first re-associating portion for the predetermined time period, a re-association information storing portion for storing the re-associated code table information and re-association information and outputting the re-association information sequentially, variable-length coding means for receiving the symbols stored in the delay and generating and sequentially outputting code words according to the re-associated code table information stored in the re-association information storing portion, and means for multiplexing and outputting the re-association information from the re-association information storing portion and the code words output from the variable-length coding means.

Said code table re-associating portion preferably re-associates said previously made code table so that, of symbols used in re-association of the code table, a symbol of a higher occurring frequency corresponds to a code word having a shorter length.

Said first re-associating portion may comprise a plurality of symbol counters for counting the number of symbols for the predetermined time period and storing the counted values, corresponding to the respective symbols, said portion generating re-associated code table information and re-association information from said previously made code table, on basis of the counted values.

Said predetermined time period may be that required to re-associate symbols to code words of a code table by using symbols obtained from video data of one slice.

Said predetermined time period may be that required to re-associate symbols to code words of a code table by using symbols obtained from video data of one video frame.

Said first re-associating portion preferably generates re-association information for respective different symbols. Said re-association information storing portion preferably outputs corresponding re-association information to said multiplexing means whenever a code word is output from said variable-length coding means.

Said re-association information storing portion may output only one set of re-association information to said multiplexing means (15) with respect to a plurality of the same code words.

Said multiplexing means may output the re-association information corresponding to a code word prior to the corresponding code word.

Said re-association information storing portion may output, to said multiplexing means, an index indicating one re-association pattern corresponding to the re-association re-association information among a plurality of patterns.

Said re-association patterns may be obtained by vector quantization (VQ) of all possible re-association patterns.

Said multiplexing means may transmit all re-association control information generated for the predetermined time period, prior to all of code words generated for the predetermined time period.

According to a second aspect of the present invention, there is provided a variable-length decoder using the symbol-code word re-association of a code table comprising a second storing portion for storing the same code table information as that previously made and stored in the first storing portion; demultiplexing means for receiving data output from the multiplexing means and dividingly outputting re-association information and code words; a second re-associating portion for receiving the re-association information from the demultiplexing means, re-associating a corresponding symbol-code word relation, and storing re-associated code table information; and variable-length decoding means for decoding an input code word on basis of the code table information stored in the second re-associating portion to thereby generate a symbol.

Said second re-associating portion preferably re-associates only the symbol-code word relation to a code word whenever said code word is input.

For a better understanding of the invention, and to show how embodiments of the same may be carried into effect, reference will now be made, by way of example, to the accompanying diagrammatic drawings, in which:
Figure 1 illustrates on example of a VLC table;
Figure 2 is a block diagram of a conventional variable-length encoder;
Figure 3 is a block diagram of a conventional variable-length decoder;
Figure 4 is a block diagram of one embodiment of variable-length encoder of the present invention;
Figure 5 is a diagram for explaining the re-association of a code table by a first re-associating circuit;
Figure 6 is a diagram for explaining actually transmitted re-association information; and
Figure 7 is a block diagram of an embodiment of a variable-length decoder of the present invention.

Referring to Figure 4, data to be variable-length coded, that is, a symbol, is applied to a delay 10 and a first re-associating circuit 13. The symbol input to the circuit shown in Figure 4 is usually composed of run and level produced by run-length coding. Delay 10 delays the symbol input for a predetermined time period and outputs the delayed symbol to encoder 11.

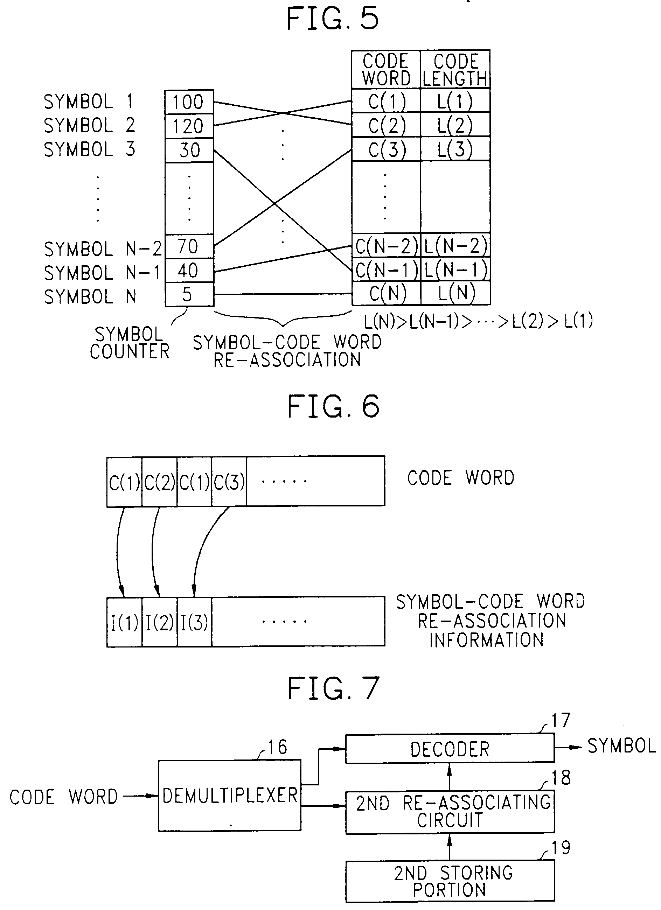

First re-associating circuit 13 receives the same symbol as that input to the delay, to re-associate the relation of symbol-code word on a code table. Particularly, first re-associating circuit 13 performs a code table re-association by using the symbols which are input for a predetermined time period. The predetermined time period is that required to gather an appropriate number of symbols for re-association of a code table, and in typical applications, it is set to one video frame or one slice. First re-associating circuit 13 reads out code table information from a storing portion 14 and stores the read-out information in a built-in memory (not shown). The operation in which first re-associating circuit 13 performs the code table re-association by using the code table information stored in the memory and the symbols input for the predetermined time period will be explained in detail with reference to Figure 5.

Referring to Figure 5, the left column represents symbol counters corresponding to respective symbols. The two right columns indicate code words corresponding to the respective symbols, and the length of the respective code words, that is, code length. The code length is L(N)>L(N-1)>...>L(2)>L(1). In other words, code word C(1) has the shortest code length, with C(N) having the longest code length. Prior to re-association of a code table, the symbol counters of Figure 5 all store "zero" as the initial value. First re-associating circuit 13 recognizes the respective symbol inputs for a predetermined time period. The respective symbol counters count a corresponding symbol and store the counted value. When the counting of the symbol inputs for the predetermined time period is finished, first re-associating circuit 13 re-associates the relation of symbol-code word on the code table, as shown in Figure 5. For instance, to "symbol 2" having a counted value 120 which is the largest, the "code word C(1)" which is the shortest is assigned. When the re-association of symbol-code word with respect to all of the symbols for the predetermined time period is finished in such a manner, first re-associating circuit 13 output re-associated code table information and symbol-code word re-association information to a re-association information storing portion 12. When the storing of the re-associated code table information and symbol-code word re-association information to a re-association information storing portion 12 is finished, re-association information storing portion 12 outputs the symbol-code word re-association information in relation with a symbol to be variable-length coded according to a loading signal applied by a controller (not shown), to a multiplexer 15. An encoder 11 converts the respective symbols applied from delay 10 into corresponding code words by using the re-associated code table information stored in re-association information storing portion 12. In the case in which encoding is finished with respect to the symbols by using the re-associated code table, code words applied to multiplexer 15 and corresponding symbol-code word re-association information will be described with reference to Figure 6.

Figure 6 shows the relation between the code words output from encoder 11 and the symbol-code word re-association information output from re-association information storing portion 12. When "code word C(1)" is generated with respect to the first symbol, encoder 11 outputs "code word C(1)," and the symbol-code word re-association information I(1) corresponding to code word C(1) provided by the re-association information storing portion 12 needs to be transmitted to decoder. When "code word C(2)" is generated with respect to the second symbol, encoder 11 outputs "code word C(2)," and in the same manner re-association information storing portion 12 needs to transmit symbol-code word re-association information I(2) corresponding to code word C(2). When "code word C(1)" is generated with respect to the third symbol, encoder 11 outputs "code word C(1)," and the symbol-code word re-association information I(1) corresponding to code word C(1) need not be transmitted since it is already specified. In this manner, all of the symbols used in producing the re-associated code table are encoded. The symbol-code word re-association information indicative of the symbol-code word relation used in the encoding, and corresponding code words generated by the encoding are output to multiplexer 15. Multiplexer 15 multiplexes and outputs input code words and symbol-code word re-association information in such a manner that the symbol-code word re-association information is output first and then corresponding code words are output. In Figure 6, for instance, second-appearing code word C(1) is transmitted but corresponding symbol-code word re-association information is not output. As a result, even when one symbol is counted several times in forming a re-associated code table, multiplexer 15 outputs only one set of symbol-code word re-association information with respect to one symbol. Symbol-code word re-association information with respect to the symbols not used in producing the re-associated code table information is not transmitted.

Various modifications may be applied to the method. First, instead of transmitting only one symbol-code word re-association information with respect to the same symbols used in producing the re-associated code table, corresponding symbol-code word re-association information may be multiplexed and transmitted whenever a code word corresponding to the same symbol is generated. Second, when the generation of the re-associated code table is finished, all of the thus obtained symbol-code word re-association information may be transmitted first and all of the code words generated by encoder 11 transmitted later. Third, re-association pattern information for making a plurality of re-associated code tables may be stored in a variable-length encoder and variable-length decoder and only indexes indicative of the re-association pattern information transmitted for variable-length coding and decoding. Here, the plurality of re-associated code tables are produced by dividing a plurality of symbols into units of predetermined time periods and using symbols for the respective predetermined time period. Fourth, when a pattern for re-association symbol-code word is determined, vector quantization may be used to further reduce the number of patterns.

Referring to Figure 7, second re-associating circuit 18 reads out a previously made code table information from second storing portion 19 and stores the information in a memory (not shown). When the code table information is stored in the memory of second re-associating circuit 18, a demultiplexer 16 receives data output from multiplexer 15 shown in Figure 4, and reversely multiplexes and outputs the data. More specifically, demultiplexer 16 divides received data into symbol-code word re-association information and code word. Demultiplexer 16 outputs the symbol-code word re-association information to second re-associating circuit 18, and the code word to decoder 17. Second re-associating circuit 18 re-associates the relation of symbol-code word of the code table previously made according to the symbol-code word re-association information applied from demultiplexer 16. The re-associated data is stored in a built-in memory (not shown). In the data output from demultiplexer 16, the symbol-code word re-association information is output first and corresponding code word is output later. Decoder 17 can output a symbol corresponding to the code word having the re-associated relation of symbol-code word on the previously made code table.

Accordingly, in embodiments of the invention even when the occurring frequency of symbols for a predetermined time period is different from that of symbols used in constructing a code table, the code length of the code words generated by variable-length coding can be reduced. This decreases the amount of data transmitted or stored when compared to the amount required when the previously made pre-defined code table is used. Further, embodiments of the present invention can efficiently transmit information for symbol-code word re-association to a decoder, increasing the compression efficiency of data transmitted to decoders.

## Claims

1. A variable-length encoder using symbol-code word re-association of a code table, the encoder comprising:
a first storing portion (14) for storing pre-defined code table information;
a first re-associating portion (13) for generating re-associated code table information and re-association information indicative of the relation of a symbol and a corresponding code word from said previously made code table information stored in said first storing portion (14), on basis of the occurring frequency of externally applied symbols for a predetermined time period;
delay means (10) for delaying and outputting the same symbols as those input to said first re-associating portion (13) for the predetermined time period;
a re-association information storing portion (12) for storing said re-associated code table information and re-association information and outputting said re-association information sequentially;
variable-length coding means (11) for receiving said symbols stored in said delay means (10) and generating and sequentially outputting code words according to said re-associated code table information stored in said re-association information storing portion (12); and
means (15) for multiplexing and outputting said re-association information from said re-association information storing portion (12) and said code words output from said variable-length coding means (11).

2. The variable-length encoder using the symbol-code word re-association of a code table as claimed in claim 1, wherein said code table re-associating portion (13) re-associates said previously made code table so that, of symbols used in re-association of the code table, a symbol of a higher occurring frequency corresponds to a code word having a shorter length.

3. The variable-length encoder using the symbol-code word re-association of a code table as claimed in claim 1 or 2, wherein said first re-associating portion (13) comprises a plurality of symbol counters for counting the number of symbols for the predetermined time period and storing the counted values, corresponding to the respective symbols, said portion generating re-associated code table information and re-association information from said previously made code table, on basis of the counted values.

4. The variable-length encoder using the symbol-code word re-association of a code table as claimed in claim 3, wherein said predetermined time period is that required to re-associate symbols to code words of a code table by using symbols obtained from video data of one slice.

5. The variable-length encoder using the symbol-code word re-association of a code table as claimed in claim 3, wherein said predetermined time period is that required to re-associate symbols to code words of a code table by using symbols obtained from video data of one video frame.

6. The variable-length encoder using the symbol-code word re-association of a code table as claimed in claim 3, 4 or 5, wherein said first re-associating portion (13) generates re-association information for respective different symbols.

7. The variable-length encoder using the symbol-code word re-association of a code table as claimed in claim 6, wherein said re-association information storing portion (12) outputs corresponding re-association information to said multiplexing means (15) whenever a code word is output from said variable-length coding means (11).

8. The variable-length encoder using the symbol-code word re-association of a code table as claimed in any of the preceding claims, wherein said re-association information storing portion (12) outputs only one set of re-association information to said multiplexing means (15) with respect to a plurality of the same code words.

9. The variable-length encoder using the symbol-code word re-association of a code table as claimed in claim 7, wherein said multiplexing means (15) outputs the re-association information corresponding to a code word prior to the corresponding code word.

10. The variable-length encoder using the symbol-code word re-association of a code table as claimed in any of the preceding claims, wherein said re-association information storing portion (12) outputs, to said multiplexing means (15), an index indicating one re-association pattern corresponding to the re-association information among a plurality of re-association patterns.

11. The variable-length encoder using the symbol-code word re-association of a code table as claimed in claim 10, wherein said re-association patterns are obtained by vector quantization (VQ) of all possible re-association patterns.

12. The variable-length encoder using the symbol-code word re-association of a code table as claimed in claim 6 or any of claims 7 to 11 as dependent upon claim 6, wherein said multiplexing means (15) transmits all of re-association control information generated for the predetermined time period, prior to all of code words generated for the predetermined time period.

13. A variable-length decoder using data output from a variable-length encoder using the symbol-code word re-association of a code table comprising a first storing portion (14) for storing a previously made code table information, a first re-associating portion (13) for generating re-associated code table information and re-association information indicative of the relation of a symbol and a corresponding code word from said previously made code table information stored in said first storing portion (14), on basis of the occurring frequency of externally applied symbols for a predetermined time period, delay means (10) for delaying and outputting the same symbols as those input to said first re-associating portion (13) for the predetermined time period, a re-association information storing portion (12) for storing said re-associated code table information and re-association information and outputting said re-association information sequentially, variable-length coding means (11) for receiving said symbols stored in said delay means (10) and generating and sequentially outputting code words according to said re-associated code table information stored in said re-association information storing portion (12), and means (15) for multiplexing and outputting said re-association information from said re-association information storing portion and said code words output from said variable-length coding means (11), said decoder comprising:
a second storing portion (19) for storing the same code table information as that previously made and stored in said first storing portion (14);
demultiplexing means (16) for receiving data output from said multiplexing means (15) and dividingly outputting symbol-codeword re-association information and code word;
a second re-associating portion (18) for receiving said re-association information from said demultiplexing means (16), re-associating a corresponding symbol-code word relation, and storing re-associated code table information; and
variable-length decoding means (17) for decoding an input code word on basis of said code table information stored in said second re-associating portion (18) to thereby generate a symbol.

14. The variable-length decoder as claimed in claim 13, wherein said second re-associating portion (18) re-associates only the symbol-code word relation to a code word whenever said code word is input.

## Patentansprüche

1. Codierer für variable Länge, der eine Symbol-Codewort-Neuzuordnung einer Codetabelle verwendet, wobei der Codierer umfaßt:
einen ersten Speicherabschnitt (14) zur Speicherung vordefinierter Codetabelleninformationen;
einen ersten Neuzuordnungsabschnitt (13) zur Erzeugung neu zugeordneter Codetabelleninformationen und Neuzuordnungsinformationen, die die Beziehung eines Symbols und eines entsprechenden Codeworts aus den vorhergehend hergestellten Codetabelleninformationen, die in dem ersten Speicherabschnitt (14) gespeichert sind, auf der Grundlage der Auftrittshäufigkeit von extern angewendeten Symbolen während einer vorbestimmten Zeitdauer angibt;
eine Verzögerungseinrichtung (10) zur Verzögerung und Ausgabe derselben Symbole während der vorbestimmten Zeitdauer wie diejenigen, die dem ersten Neuzuordnungsabschnitt (13) eingegeben werden;
ein Neuzuordnungs-Informationsspeicherabschnitt (12) zur Speicherung der neu zugeordneten Codetabelleninformationen und der Neuzuordnungsinformationen und zur sequentiellen Ausgabe der Neuzuordnungsinformationen;
eine Codierungseinrichtung (11) für variable Länge, die die in der Verzögerungseinrichtung (10) gespeicherten Symbole erhält und Codewörter entsprechend den neu zugeordneten Codetabelleninformationen erzeugt und sequentiell ausgibt, die in dem Neuzuordnungs-Informationsabschnitt (12) gespeichert sind; und
eine Einrichtung (15) zum Multiplexen und Ausgeben der Neuzuordnungsinformationen von dem Neuzuordnungs-Informationsspeicherabschnitt (12) und der Codewörter, die von der Codierungseinrichtung (11) für variable Länge ausgegeben werden.

2. Codierer für variable Länge, der die Symbol-Codewort-Neuzuordnung einer Codetabelle verwendet, wie in Anspruch 1 beansprucht, wobei der Codetabellen-Neuzuordnungsabschnitt (13) die vorhergehend hergestellte Codetabelle derart neu zuordnet, daß von den Symbolen, die in der Neuzuordnung der Codetabelle verwendet werden, ein Symbol mit einer höheren Auftrittshäufigkeit einem Codewort mit einer kürzeren Länge entspricht.

3. Codierer für variable Länge, der die Symbol-Codewort-Neuzuordnung einer Codetabelle verwendet, wie in Anspruch 1 oder 2 beansprucht, wobei der erste Neuzuordnungsabschnitt (13) eine Mehrzahl Symbolzähler umfaßt, die den entsprechenden Symbolen entspricht, um die Anzahl der Symbole während der vorbestimmten Zeitdauer zu zählen und die gezählten Werte zu speichern, wobei der Abschnitt neu zugeordnete Codetabelleninformationen und Neuzuordnungsinformationen von der vorhergehend hergestellten Codetabelle auf der Grundlage der gezählten Werte erzeugt.

4. Codierer für variable Länge, der die Symbol-Codewort-Neuzuordnung einer Codetabelle verwendet, wie in Anspruch 3 beansprucht, wobei die vorbestimmte Zeitdauer diejenige ist, die verlangt wird, Symbole den Codewörtern einer Codetabelle neu zuzuordnen, wobei Symbole verwendet werden, die von Videodaten einer Scheibe erhalten werden.

5. Codierer für variable Länge, der die Symbol-Codewort-Neuzuordnung einer Codetabelle verwendet, wie in Anspruch 3 beansprucht, wobei die vorbestimmte Zeitdauer diejenige ist, die verlangt wird, Symbole den Codewörtern einer Codetabelle neu zuzuordnen, wobei Symbole verwendet werden, die von Videodaten eines Vollbilds erhalten werden.

6. Codierer für variable Länge, der die Symbol-Codewort-Neuzuordnung einer Codetabelle verwendet, wie in Anspruch 3, 4 oder 5 beansprucht, wobei der erste Neuzuordnungsabschnitt (13) Neuzuordnungsinformationen für entsprechende unterschiedliche Symbole erzeugt.

7. Codierer für variable Länge, der die Symbol-Codewort-Neuzuordnung einer Codetabelle verwendet, wie in Anspruch 6 beansprucht, wobei der Neuzuordnungs-Informationsspeicherabschnitt (12) entsprechende Neuzuordnungsinformationen an die Multiplexeinrichtung (15) ausgibt, wenn immer ein Codewort von der Codiereinrichtung (11) für variable Länge ausgegeben wird.

8. Codierer für variable Länge, der die Symbol-Codewort-Neuzuordnung einer Codetabelle verwendet, wie in irgendeinem der vorhergehenden Ansprüche beansprucht, wobei der Neuzuordnungs-Informationsspeicherabschnitt (12) nur einen Satz Neuzuordnungsinformationen an die Multiplexeinrichtung (15) in bezug auf eine Mehrzahl der gleichen Codewörter ausgibt.

9. Codierer für variable Länge, der die Symbol-Codewort-Neuzuordnung einer Codetabelle verwendet, wie in Anspruch 7 beansprucht, wobei die Multiplexeinrichtung (15) die Neuzuordnungsinformation, die einem Codewort entspricht, vor dem entsprechenden Codewort ausgibt.

10. Codierer für variable Länge, der die Symbol-Codewort-Neuzuordnung einer Codetabelle verwendet, wie in irgendeinem der vorhergehenden Ansprüche beansprucht, wobei der Neuzuordnungs-Informationsspeicherabschnitt (12) an die Multiplexeinrichtung (15) einen Index ausgibt, der ein Neuzuordnungsmuster, das den Neuzuordnungsinformationen entspricht, aus einer Mehrzahl von Neuzuordnungsmustern angibt.

11. Codierer für variable Länge, der die Symbol-Codewort-Neuzuordnung einer Codetabelle verwendet, wie in Anspruch 10 beansprucht, wobei die Neuzuordnungsmuster durch Vektordigitalisierung (VQ) aller möglicher Neuzuordnungsmuster erhalten werden.

12. Codierer für variable Länge, der die Symbol-Codewort-Neuzuordnung einer Codetabelle verwendet, wie in Anspruch 6 oder irgendeinem der Ansprüche 7 bis 11, wenn von Anspruch 6 abhängig, beansprucht, wobei die Multiplexeinrichtung (15) alle Neuzuordnungssteuerinformationen, die während der vorbestimmten Zeitdauer erzeugt wurden, vor allen Codewörtern überträgt, die während der vorbestimmten Zeitdauer erzeugt wurden.

13. Codierer für variable Länge, der Daten verwendet, die von einem Codierer für variable Länge ausgegeben werden, der die Symbol-Codewort-Neuzuordnung einer Codetabelle verwendet, umfassend einen ersten Speicherabschnitt (14) zur Speicherung vorhergehend hergestellter Codetabelleninformationen, einen ersten Neuzuordnungsabschnitt (13) zur Erzeugung neu zugeordneter Codetabelleninformationen und Neuzuordnungsinformationen, die die Beziehung eines Symbols und eines entsprechenden Codeworts aus den vorhergehend hergestellten Codetabelleninformationen, die in dem ersten Speicherabschnitt (14) gespeichert sind, auf der Grundlage der Auftrittshäufigkeit von extern angewendeten Symbolen während einer vorbestimmten Zeitdauer angibt, eine Verzögerungseinrichtung (10) zur Verzögerung und Ausgabe derselben Symbole während der vorbestimmten Zeitdauer wie diejenigen, die dem ersten Neuzuordnungsabschnitt (13) eingegeben werden, ein Neuzuordnungs-Informationsspeicherabschnitt (12) zur Speicherung der neu zugeordneten Codetabelleninformationen und der Neuzuordnungsinformationen und zur sequentiellen Ausgabe der Neuzuordnungsinformationen, eine Codierungseinrichtung (11) für variable Länge, die die in der Verzögerungseinrichtung (10) gespeicherten Symbole erhält und Codewörter entsprechend den neu zugeordneten Codetabelleninformationen erzeugt und sequentiell ausgibt, die in dem Neuzuordnungs-Informationsabschnitt (12) gespeichert sind; und eine Einrichtung (15) zum Multiplexen und Ausgeben der Neuzuordnungsinformationen von dem Neuzuordnungs-Informationsspeicherabschnitt (12) und der Codewörter, die von der Codierungseinrichtung (11) für variable Länge ausgegeben werden,
wobei der Decodierer umfaßt:
einen zweiten Speicherabschnitt (19) zur Speicherung der gleichen Codetabelleninformationen wie die vorhergehend hergestellten und in dem ersten Speicherabschnitt (14) gespeicherten;
eine Demultiplexeinrichtung (16), die den Datenausgang von der Multiplexeinrichtung (15) erhält und Symbol-Codewort-Neuzuordnungsinformationen und Codewörter unterteilend ausgibt;
einen zweiten Neuzuordnungsabschnitt (18), der die Neuzuordnungsinformationen von der Demultiplexeinrichtung (16) erhält, eine entsprechende Symbol-Codewort-Beziehung neu zuordnet, und die neu zugeordneten Codetabelleninformationen speichert; und
eine variable Länge-Decodierereinrichtung (17) zur Decodierung eines eingegebenen Codeworts auf der Grundlage der Codetabelleninformationen, die in dem zweiten Neuzuordnungsabschnitt (18) gespeichert sind, um dadurch ein Symbol zu erzeugen.

14. Codierer für variable Länge, wie in Anspruch 13 beansprucht, wobei der zweite Neuzuordnungsabschnitt (18) nur die Symbol-Codewort-Beziehung zu einem Codewort neu zuordnet, wenn immer das Codewort eingegeben wird.

## Revendications

1. Codeur de mots codes de longueur variable utilisant une réassociation de symbole / mot code d'un tableau de codes, le codeur comprenant :
une première partie de stockage (14) destinée à stocker des informations de tableau de codes prédéfinies ;
une première partie de réassociation (13) destinée à générer des informations de tableau de codes réassociées et des informations de réassociation indiquant la relation entre un symbole et un mot code correspondant à partir desdites informations de tableau de codes créées précédemment stockées dans ladite première partie de stockage (14), sur la base de la fréquence d'apparition des symboles appliqués de manière externe sur une période de temps prédéterminée ;
un moyen de temporisation (10) destiné à temporiser et sortir les mêmes symboles que ceux entrés sur ladite première partie de réassociation (13) sur la période de temps prédéterminée ;
une partie de stockage des informations de réassociation (12) destinée à stocker lesdites informations de tableau de codes réassociées et lesdites informations de réassociation et à sortir lesdites informations de réassociation de manière séquentielle ;
un moyen de codage de mots codes de longueur variable (11) destiné à recevoir lesdits symboles stockés dans ledit moyen de temporisation (10) et à générer et sortir de manière séquentielle des mots codes en fonction desdites informations de tableau de codes réassociées stockées dans ladite partie de stockage des informations de réassociation (12) ; et
un moyen (15) destiné à multiplexer et sortir lesdites informations de réassociation à partir de ladite partie de stockage des informations de réassociation (12) et desdits mots codes sortis par le moyen de codage de mots codes de longueur variable (11).

2. Codeur de mots codes de longueur variable utilisant une réassociation de symbole / mot code d'un tableau de codes selon la revendication 1, dans lequel ladite partie de réassociation de tableau de codes (13) réassocie ledit tableau de codes créé précédemment afin que, parmi les symboles utilisés pour la réassociation du tableau de codes, un symbole ayant une fréquence d'apparition plus grande corresponde à un mot code ayant une longueur plus courte.

3. Codeur de mots codes de longueur variable utilisant une réassociation de symbole / mot code d'un tableau de codes selon la revendication 1 ou 2, dans lequel ladite première partie de réassociation (13) comprend une pluralité de compteurs de symboles, destinés à compter le nombre de symboles sur une période de temps prédéterminée et à stocker les valeurs comptées, correspondant aux symboles respectifs, ladite partie générant les informations de tableau de codes réassociées et les informations de réassociation à partir dudit tableau de codes créé précédemment, sur la base des valeurs comptées.

4. Codeur de mots codes de longueur variable utilisant une réassociation de symbole / mot code d'un tableau de codes selon la revendication 3, dans lequel ladite période de temps prédéterminée est celle requise pour réassocier des symboles aux mots codes d'un tableau de codes en utilisant des symboles obtenus à partir de données vidéo sur une tranche de temps.

5. Codeur de mots codes de longueur variable utilisant une réassociation de symbole / mot code d'un tableau de codes selon la revendication 3, dans lequel ladite période de temps prédéterminée est celle requise pour réassocier des symboles aux mots codes d'un tableau de codes en utilisant des symboles obtenus à partir de données vidéo d'une image vidéo.

6. Codeur de mots codes de longueur variable utilisant une réassociation de symbole / mot code d'un tableau de codes selon l'une des revendications 3, 4 ou 5, dans lequel ladite première partie de réassociation (13) génère des informations de réassociation pour des symboles différents respectifs.

7. Codeur de mots codes de longueur variable utilisant une réassociation de symbole / mot code d'un tableau de codes selon la revendication 6, dans lequel ladite partie de stockage des informations de réassociation (12) sort des informations de réassociation correspondantes sur ledit moyen de multiplexage (15) chaque fois qu'un mot code est sorti par ledit moyen de codage de mots codes de longueur variable (11).

8. Codeur de mots codes de longueur variable utilisant une réassociation de symbole / mot code d'un tableau de codes selon l'une quelconque des revendications précédentes, dans lequel ladite partie de stockage des informations de réassociation (12) sort uniquement un ensemble d'informations de réassociation sur ledit moyen de multiplexage (15) concernant une pluralité de mots codes identiques.

9. Codeur de mots codes de longueur variable utilisant une réassociation de symbole / mot code d'un tableau de codes selon la revendication 7, dans lequel ledit moyen de multiplexage (15) sort des informations de réassociation correspondant à un mot code avant le mot code correspondant.

10. Codeur de mots codes de longueur variable utilisant une réassociation de symbole / mot code d'un tableau de codes selon l'une quelconque des revendications précédentes, dans lequel ladite partie de stockage des informations de réassociation (12) sort, sur ledit moyen de multiplexage (15), un indice indiquant un modèle de réassociation correspondant aux informations de réassociation parmi une pluralité de modèles de réassociation.

11. Codeur de mots codes de longueur variable utilisant une réassociation de symbole / mot code d'un tableau de codes selon la revendication 10, dans lequel lesdits modèles de réassociation sont obtenus par quantification vectorielle (QV) de tous les modèles de réassociation possibles.

12. Codeur de mots codes de longueur variable utilisant une réassociation de symbole / mot code d'un tableau de codes selon la revendication 6 ou l'une quelconque des revendications 7 à 11 dépendant de la revendication 6, dans lequel ledit moyen de multiplexage (15) transmet toutes les informations de commande de réassociation générées sur la période de temps prédéterminée, avant tous les mots codes générés sur la période de temps prédéterminée.

13. Décodeur de mots codes de longueur variable utilisant une sortie de données provenant d'un codeur de mots codes de longueur variable utilisant la réassociation de symbole / mot code d'un tableau de codes comprenant une première partie de stockage (14) destinée à stocker des informations de tableau de codes créées précédemment, une première partie de réassociation (13) destinée à générer des informations de tableau de codes réassociées et des informations de réassociation indiquant la relation entre un symbole et un mot code correspondant à partir desdites informations de tableau de codes créées précédemment stockées dans ladite première partie de stockage (14), sur la base de la fréquence d'apparition des symboles appliqués de manière externe sur une période de temps prédéterminée, un moyen de temporisation (10) destiné à temporiser et sortir les mêmes symboles que ceux entrés sur ladite première partie de réassociation (13) sur la période de temps prédéterminée, une partie de stockage des informations de réassociation (12) destinée à stocker lesdites informations de tableau de codes réassociées et lesdites informations de réassociation et à sortir lesdites informations de réassociation de manière séquentielle, un moyen de codage de mots codes de longueur variable (11) destiné à recevoir lesdits symboles stockés dans ledit moyen de temporisation (10) et à générer et sortir de manière séquentielle des mots codes en fonction desdites informations de tableau de codes réassociées stockées dans ladite partie de stockage des informations de réassociation (12), et un moyen (15) destiné à multiplexer et sortir lesdites informations de réassociation à partir de ladite partie de stockage des informations de réassociation et desdits mots codes sortis par le moyen de codage de mots codes de longueur variable (11), ledit décodeur comprenant :
une deuxième partie de stockage (19) destinée à stocker les mêmes informations de tableau de codes que celles créées précédemment et stockées dans ladite première partie de stockage (14) ;
un moyen de démultiplexage (16) destiné à recevoir les données sorties par ledit moyen de multiplexage (15) et à sortir en les séparant les informations de réassociation de symbole / mot code et le mot code ;
une deuxième partie de réassociation (18) destinée à recevoir lesdites informations réassociées dudit moyen de démultiplexage (16), à réassocier une relation symbole / mot code correspondante et à stocker les informations de tableau de codes réassociées ; et
un moyen de décodage de mots codes de longueur variable (17) destiné à décoder un mot code entré sur la base desdites informations de tableau de codes stockées dans ladite deuxième partie de réassociation (18) afin de générer ainsi un symbole.

14. Décodeur de mots codes de longueur variable selon la revendication 13, dans lequel la deuxième partie de réassociation (18) réassocie uniquement la relation symbole / mot code à un mot code lorsque ledit mot code est entré.
